# EUROPÄISCHE PATENTSCHRIFT

(11) **EP 1 330 147 B1**
(45) Veröffentlichungstag und Bekanntmachung des Hinweises auf die Patenterteilung: **26.03.2008**
(21) Anmeldenummer: 03000158.0
(22) Anmeldetag: 07.01.2003
(51) Int. Cl.: H05K 5/00

(54) **Modulares Steuerungsgehäuse**
Modular control housing
Boîtier modulaire de commande

(30) Priorität: 18.01.2002 DE 20200720 U
(43) Veröffentlichungstag der Anmeldung: 23.07.2003
(73) Patentinhaber: Harting Electric GmbH & Co. KG, 32339 Espelkamp (DE)
(72) Erfinder: Kruke, Nicole, 32312 Lübbecke (DE); Schmidt, Martin, 32312 Lübbecke (DE); Schwettmann, Hartmut, 32369 Rahden (DE); Sundermeier, Uwe, 32339 Espelkamp (DE)

(56) Entgegenhaltungen:
- DE-U- 20 112 595
- FR-A- 2 716 767

## Beschreibung

Die Erfindung betrifft ein modulares Steuerungsgehäuse, insbesondere ein quaderförmig ausgebildetes Gehäuse, das aus zwei verbindbaren, gleichartigen Gehäuseschalen zusammengefügt ist.

Ein derartiges modular aufgebautes Gehäuse wird benötigt, um elektronische Steuerungselemente, Statusanzeigen oder sonstige Komponenten zusammen mit einer oder mehreren Steckverbindungen in einer industriellen Umgebung dezentral, unmittelbar an den Verbraucher heranzuführen.

Es ist bekannt im industriellen Bereich elektronische Komponenten zur Steuerung von Motoren und Sensoren überwiegend in Metallgehäusen unterzubringen, um sie vor Berührungen und der teilweise aggressiven Industrieatmosphäre zu schützen.
Weiterhin ist auch bekannt, z.B. aus der DE-U-201 12 595, überwiegend aus Kunststoffen gefertigte Gehäuse aus verbindbaren Halbschalen herzustellen, die zur Aufnahme von Elektronikequipment vorgesehen sind und teils für einen kabellosen Betrieb und teils als kabelgebundene Adaptergehäuse genutzt werden.

Nachteilig wirkt sich bei derartigen Gehäusen aus, dass sie jedoch größtenteils nicht in rauher Industrieumgebung genutzt werden können, und dass ein variabler Einsatz mit nur einer Gehäuseversion nicht gegeben ist.

Der Erfindung liegt daher die Aufgabe zugrunde, ein modular aufgebautes Steuerungsgehäuse der eingangs genannten Art dahingehend auszubilden, dass das Gehäuse für den industriellen Einsatz mit schweren Steckverbindern genutzt werden kann, wobei gleichzeitig Steuerungs- oder Anzeigemöglichkeiten durch ein integriertes elektronisches Equipment ermöglicht wird.

Diese Aufgabe wird dadurch gelöst, dass in den Eckbereichen der Gehäuseschalen senkrecht zur Gehäuseschale angeformte Winkel vorgesehen sind, deren Stirnflächen bei der Montage der Gehäuseschalen aneinanderstoßen, dass in den Eckbereichen von den Winkeln beabstandete, innere Pfosten vorgesehen sind, wobei die Pfosten verkürzt gegenüber den Winkeln ausgebildet sind, dass in den Gehäuseschalen eine umlaufende Nut eingeformt ist, die zwischen den Winkeln und den Pfosten verläuft, dass eine einstückige, elastische Dichtung mit einer Dichtschnur in die umlaufende Nut einfügbar ist, dass an der Dichtung angeformte Eckstücke zwischen die beabstandeten Winkel und Pfosten ragen, und dass an den Eckstücken vorgesehene Anformungen auf Stirnflächen der Pfosten aufliegen.

Vorteilhafte Ausgestaltungen der Erfindung sind in den Ansprüchen 2 - 8 angegeben.

Die mit der Erfindung erzielten Vorteile bestehen insbesondere darin, daß mit dem modular aufgebauten Steuerungsgehäuse ein variabler Aufbau eines industrietauglichen Gehäuses ermöglicht wird, bei dem im Zuge der Dezentralisierung von Steuerungsaufgaben hin zum Verbraucher, ein elektronisches Equipment eingebaut werden kann, wobei gleichzeitig ein oder mehrere Steckverbinder in entsprechenden Adaptern an das Steuerungsgehäuse montierbar sind.
Das Steuerungsgehäuse besteht im Wesentlichen aus zwei Halbschalen, die mittels herausgeformter Pfosten und darin eingelassener Schrauben miteinander verbindbar sind.
Alle vier Schmalseiten des quaderförmigen Gehäuses sind mit Öffnungen versehen, die sich zwischen den Pfosten ergeben, in die entweder ein Blechteil zum Verschließen der jeweiligen Seite oder ein Adapter zur Aufnahme von beispielsweise Steckverbinden eingesetzt werden kann.

Die Blechteile sind vorteilhafterweise an ihren Schmalseiten mit von der Mitte ausgehend zu den Rändern verlaufenden Abschrägungen versehen, so dass sie fest in die mit einer umlaufenden Nut versehene Öffnung des Gehäuses einsetzbar sind.
Weiterhin sind im Inneren des Gehäuses Montage- oder Leiterplatten auf sockelartigen Auflagen montierbar.
Durch den Einsatz einer umlaufenden Gummidichtung ist vorteilhaft ein staub- und spritzwasserdichtes Gehäuse mit einer Schutzart bis IP 65 zur Verwendung in rauher Industrieumgebung verfügbar.
Weiterhin ist ein solches Gehäuse auch innerhalb von Schaltschränken an DIN-Tragschienen zu befestigen oder sonst beliebig montierbar.

Ein Ausführungsbeispiel der Erfindung ist in der Zeichnung dargestellt und wird im folgenden näher erläutert. Es zeigen:
- Fig. 1: eine perspektivische Ansicht eines kompletten Steuerungsgehäuses,
- Fig. 2: ein aus zwei Gehäuseschalen gebildetes Steuerungsgehäuse,
- Fig. 3: eine Seitenansicht eines Adapters,
- Fig. 4: eine Draufsicht auf ein Blechteil,
- Fig. 5: eine perspektivische Darstellung einer Dichtung,
- Fig. 6a: eine Draufsicht auf die Innenseite einer Gehäuseschale,
- Fig. 6b: Teilschnitt eines Eckbereiches der Gehäuseschale, und
- Fig. 7: eine Ansicht eines geöffneten Steuerungsgehäuses.

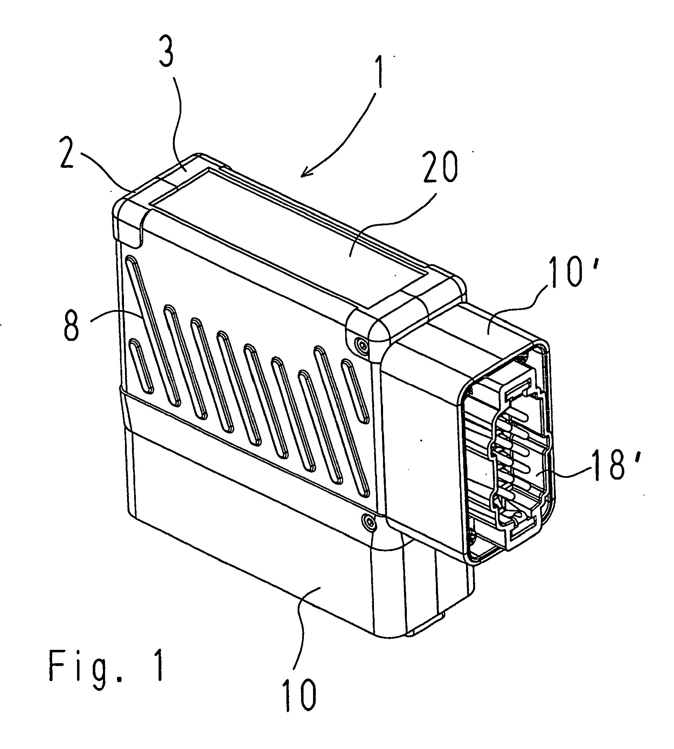

In der Fig.1 ist in einer perspektivischen Ansicht ein komplettes erfindungsgemäßes Steuerungsgehäuse 1 mit einem sichtbar dargestellten Steckverbinder gezeigt.
An dem aus zwei Gehäusehälften 2, 3 gebildeten Gehäuse sind zwei Adapter 10, 10' angefügt sowie zwei Blechteile 20, von denen jedoch nur eines sichtbar ist. Innerhalb des kleineren Adapters 10' ist ein Steckverbinder 18' eingefügt.

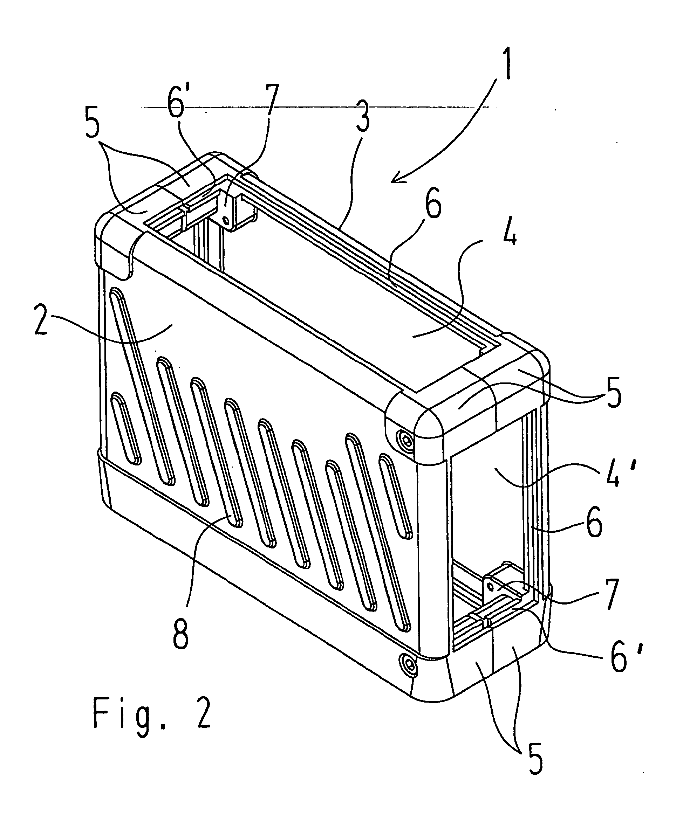

Die Fig. 2 zeigt in einer perspektivischen Darstellung die beiden zusammengefügten Gehäusehälften 2, 3, die durch angeformte Winkel 5 an jeder der Eckpunkte und mittels darin integrierter Verschraubungen zusammengehalten sind.
Zwischen den Winkeln sind Ausnehmungen 4, 4' gebildet, die in ihren Innenrändern jeweils eine umlaufende Nut 6, 6' beinhalten.
Jeweils in den Eckpunkten der Gehäusehälften sind Auflagen 7 zur Befestigung einer Leiterplatte oder einer Montageplatte im Inneren des Gehäuses vorgesehen. Die Außenfläche der Gehäusehälften ist mit schräg angeordneten Profilstreifen 8 versehen, um bei einem Entfernen eines mit einem Steckverbinder ausgerüsteten Gehäuses 1 eine grifffeste Oberfläche zu bieten.

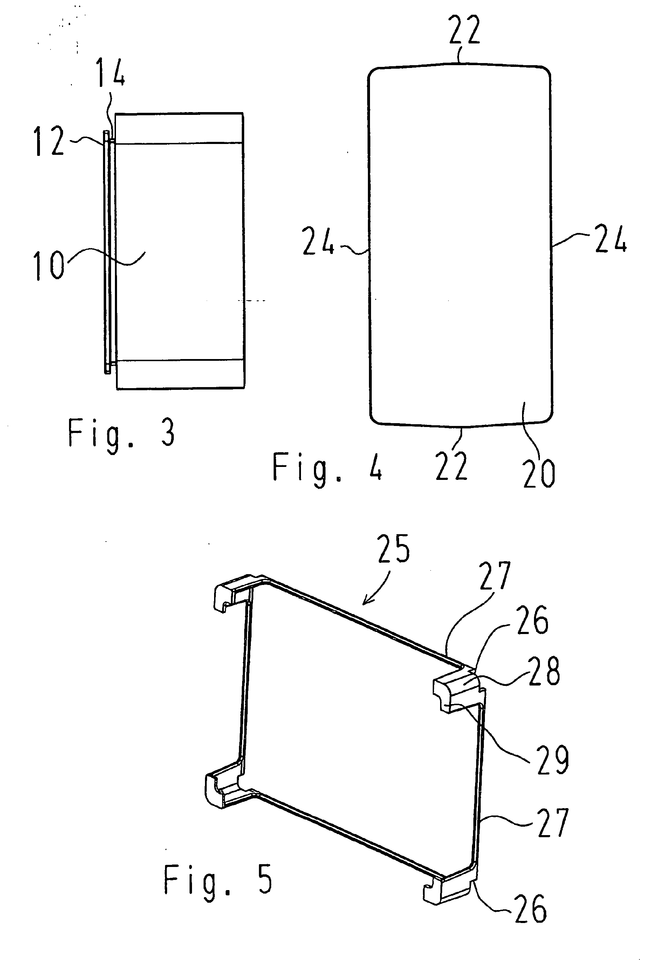

Die Fig. 3 zeigt einen Adapter 10 in einer Seitenansicht, wobei ein Profil erkennbar ist, das aus einem Kragen 12 und einer sich zwangsläufig ergebenden Nut 14 gebildet ist. Der Adapter wird bei seiner Montage in eine der Ausnehmungen 4, 4' des Gehäuses 1 mit dem Kragen 12 in die Nut 6, 6' eingesetzt.

Der Kragen 12 hat in seiner Außenkontour die gleiche Form wie das in der Fig. 4 gezeigte Blechteil 20.
Das ebenfalls eine Rechteckform aufweisende Blechteil ist an seinen Schmalseiten mit einer von der Blechmitte 22 zu den Rändern 24 ausgehenden symmetrischen Abschrägung versehen.

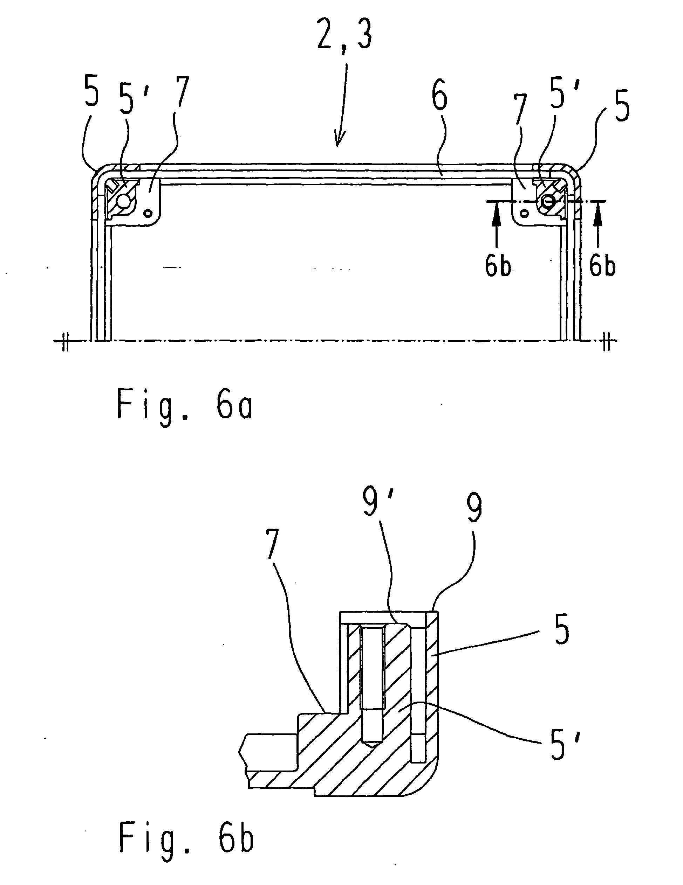

Die längere Blechmitte gegenüber den Rändern bewirkt eine stets sichere und feste, verkantungsfreie Verbindung zwischen den Gehäuseschalen und den Blechteilen sowie den eingesetzten Adaptern.
In der Fig. 5 ist eine einstückige Dichtung 25 gezeigt, die für den Einsatz in die umlaufende Nut 6, 6' in den Gehäuseschalen 2, 3 vorgesehen ist.
Gegenüber einer normalen Gummidichtung, die kreisförmig und eventuell mit unterschiedlichen Querschnitten geformt ist, weist diese Dichtung eine Besonderheit auf, in dem in den Eckpunkten der Dichtschnur 27 senkrecht hervorstehend, winkelförmige Eckstücke 28 mit einer Anformung 29 vorgesehen sind.
In den Eckstücken ist weiterhin jeweils eine Ausnehmung 26 vorgesehen, mit einer Höhe von mindestens der Dicke der Dichtschnur 27, mit der durch eine entsprechende Gegenform im Eckbereich der umlaufenden Nut 6 in der Gehäuseschale eine passgenaue Festlegung der Dichtung erzielt wird.
Beim Einfügen einer Dichtung in jeweils eine der beiden Gehäuseschalen 2, 3 wird nicht nur die jeweilige Nut 6, 6' mit der Dichtschnur 27 ausgefüllt, sondern es werden auch die in Fig. 6 näher beschriebenen Pfosten 5' abgedeckt.
Somit verfügt jede der beiden Gehäuseschalen über eine eigene umlaufende Dichtung, die bei der Montage der beiden Gehäuseschalen wiederum eine umlaufende Dichtung in jeder der Ausnehmungen 4, 4' ergibt und bei Nutzung nur der Einsatzbleche ein wasserdichtes Gehäuse zur Folge hat.

In den Fig. 6a und 6b sind in einer Draufsicht bzw. in einem Detailschnitt die Innenseite einer offenen Gehäuseschale 2, 3 sowie Einzelheiten der Eckbereiche gezeigt.
Der Winkel 5 ist mit der Stirnfläche 9 für die gegenseitige Auflage der Gehäuseschalen vorgesehen und ist in dem Beispiel als von außen sichtbarer Teil verrundet. Mit dem innenliegenden Pfosten 5' ist der Winkel 5 zwar gemeinsam an der Gehäuseschale angeformt aber überwiegend durch einen Schlitz getrennt, durch den die umlaufende Nut 6 für die Dichtschnur der Dichtung 25 geführt ist. In diesen Schlitz wird bei der Montage des Gehäuses jeweils ein schalenförmiges Eckstück 28 der Dichtung 25 eingeschoben, wobei die Anformung 29 auf der Stirnfläche des Pfostens 5' zumindest teilweise aufliegt.
Um bei der Montage dicht beieinander liegende Gehäuseschalen zu gewährleisten, ist die Länge des inneren Pfostens 5' gegenüber dem Winkel 5 verkürzt ausgeführt, so dass genügend Platz für die auf der Stirnfläche 9' aufliegende Anformung 29 der Dichtung bleibt. (siehe dazu Fig. 6b)
Auf der Stirnfläche 9' des Pfosten 5' ist zudem eine hier nicht weiter bezeichnete Bohrung für die gegenseitige Schraubbefestigung der beiden Gehäuseschalen 2, 3 vorgesehen.

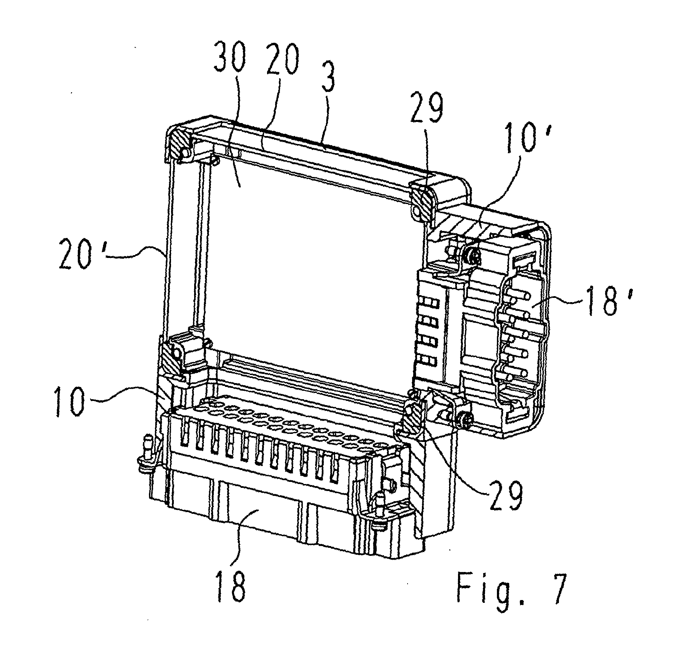

Die Fig. 7 zeigt ein geöffnetes Gehäuse bei dem die obere Gehäuseschale entfernt ist, wobei zwei Adapter 10, 10' sowie zwei Blechteile 20, 20' an einer der Schmalseiten eingefügt sind.
In den Adaptern sind jeweils passende Steckverbinder 18, 18' eingelegt. Weiterhin ist in der Gehäusehälfte ein Montageblech 30 (oder auch eine Leiterplatte) gezeigt, worauf elektrische bzw. elektronische Komponenten aufbringbar sind. Ähnlich können auch die Blechteile 20, 20' mit Anzeige- oder Schaltmitteln versehen sein.
Wie aus der Fig. 7 weiterhin zu entnehmen ist, kann der Einsatz bezüglich der Adapter bzw. der Blechteile, in den insgesamt vier seitlichen Öffnungen beliebig gestaltet werden, von einem komplett mit Blechteilen umschlossenen Gehäuse bis zu einem Vierfach-Stecker. Wobei unter Einsatz der bereits in Fig. 5 beschriebenen Dichtung 25 ein staub- und spritzwasserdichtes ausgebildetes Gehäuse möglich ist.

## Patentansprüche

1. Modulares Steuerungsgehäuse, insbesondere ein quaderförmig ausgebildetes Gehäuse (1), das aus zwei verbindbaren, gleichartigen Gehäuseschalen (2, 3) zusammengefügt ist, **dadurch gekennzeichnet, dass** in den Eckbereichen der Gehäuseschalen senkrecht zur Gehäuseschale (2, 3) angeformte Winkel (5) vorgesehen sind, deren Stirnflächen (9) bei der Montage der Gehäuseschalen aneinanderstoßen, dass in den Eckbereichen von den Winkeln (5) beabstandete, innere Pfosten (5') vorgesehen sind, wobei die Pfosten verkürzt gegenüber den Winkeln ausgebildet sind,
dass in den Gehäuseschalen (2, 3) eine umlaufende Nut (6) eingeformt ist, die zwischen den Winkeln (5) und den Pfosten (5') verläuft, dass eine einstückige, elastische Dichtung (25) mit einer Dichtschnur (27) in die umlaufende Nut (6) einfügbar ist,
dass an der Dichtung angeformte Eckstücke (28) zwischen die beabstandeten Winkel (5) und Pfosten (5') ragen, und
dass an den Eckstücken (28) vorgesehene Anformungen (29) auf Stirnflächen (9') der Pfosten (5') aufliegen.

2. Modulares Steuerungsgehäuse nach Anspruch 1, **dadurch gekennzeichnet,**
**dass** in den Rändern der Winkel (5) eine Nut (6') vorgesehen ist, die senkrecht auf die umlaufende Nut (6) trifft.

3. Modulares Steuerungsgehäuse nach Anspruch 1 oder 2, **dadurch gekennzeichnet,**
**dass** in durch die Winkel (5) gebildeten Öffnungen (4, 4') des Gehäuses mindestens ein Adapter (10) mit darin einsetzbaren elektrischen Anschlusselementen formschlüssig einfügbar ist.

4. Modulares Steuerungsgehäuse nach einem der vorstehenden Ansprüche, **dadurch gekennzeichnet,**
**dass** der Adapter (10,10') mit einem umlaufenden Kragen (12) versehen ist, der in die umlaufende Nut (6, 6') der Öffnung (4, 4') eingreift.

5. Modulares Steuerungsgehäuse nach einem der vorstehenden Ansprüche, **dadurch gekennzeichnet,**
**dass** ein rechteckig geformtes Blechteil (20, 20') in die umlaufende Nut (6, 6') der Öffnungen (4, 4') einfügbar ist, wobei das Blechteil an den Schmalseiten von der Mitte (22) ausgehend zu den Rändern (24) Abschrägungen aufweist.

6. Modulares Steuerungsgehäuse nach einem der vorstehenden Ansprüche, **dadurch gekennzeichnet,**
**dass** in dem Gehäuse (1) mindestens eine Montage- oder Leiterplatte (30) auf einer sockelartigen Auflage (7) montierbar ist.

7. Modulares Steuerungsgehäuse nach einem der vorstehenden Ausprüche, **dadurch gekennzeichnet,**
**dass** die in den Adapter (10, 10') einfügbaren elektrischen Anschlusselemente als Steckverbinder (18, 18') ausgebildet sind.

8. Modulares Steuerungsgehäuse nach einem der vorstehenden Ansprüche, **dadurch gekennzeichnet,**
**dass** die Außenfläche der Gehäuseschale (2, 3) mit erhabenen Profilstreifen (8) versehen ist.

## Claims

1. A modular control casing, in particular a casing (1) which is in the shape of a right parallelepiped and is joined together from two casing shells (2, 3) of the same kind that can be connected, **characterized in that**
integrally moulded angles (5) are provided perpendicularly to the casing shell (2, 3) in the corner regions of the casing shells, the angles (5) having end faces (9) that abut against each other when the casing shells are mounted,
inner posts (5') that are spaced apart from the angles (5) are provided in the corner regions, the posts being made shorter in relation to the angles,
an encircling groove (6) is formed in the casing shells (2, 3) which runs between the angles (5) and the posts (5'),
a one-piece elastic seal (25) having a sealing cord (27) is adapted to be inserted into the encircling groove (6),
corner pieces (28) integrally moulded with the seal project between the angles (5) and the posts (5') spaced apart from one another, and
integrally moulded portions (29) provided on the corner pieces (28) rest on end faces (9') of the posts (5').

2. The modular control casing according to claim 1, **characterized in that**
provided in the edges of the angles (5) is a groove (6') that encounters the encircling groove (6) at right angles.

3. The modular control casing according to claim 1 or 2, **characterized in that**
at least one adapter (10) having electric connecting members insertable therein can be inserted with an interlocking fit into openings (4, 4') of the casing formed by the angles (5).

4. The modular control casing according to any of the preceding claims, **characterized in that**
the adapter (10, 10') is provided with a surrounding collar (12) engaging into the encircling groove (6, 6') of the opening (4, 4').

5. The modular control casing according to any of the preceding claims, **characterized in that**
a sheet metal part (20, 20') having a rectangular shape is adapted to be inserted into the encircling groove (6, 6') of the openings (4, 4'), the sheet metal part having bevelled portions on the narrow sides starting from the middle (22) towards the edges (24).

6. The modular control casing according to any of the preceding claims, **characterized in that**
at least one mounting plate or printed circuit board (30) can be fitted in the casing (1) on a base-type support (7).

7. The modular control casing according to any of the preceding claims, **characterized in that**
the electric connecting members that can be inserted into the adapter (10, 10') are in the form of plug connectors (18, 18').

8. The modular control casing according to any of the preceding claims, **characterized in that**
the outer surface of the casing shell (2, 3) is provided with raised profiled strips (8).

## Revendications

1. Boîtier de commande modulaire, en particulier un boîtier (1) réalisé sous forme de parallélépipède et assemblé à partir de deux coquilles (2, 3) de boîtier semblables qui peuvent être reliées, **caractérisé en ce que**
des angles (5) conformés sont prévus dans les zones de coin des coquilles de boîtier et perpendiculairement à la coquille de boîtier (2, 3), les faces frontales (9) des angles (5) butant l'une contre l'autre lors du montage des coquilles de boîtier,
des montants intérieurs (5') espacés des angles (5) sont prévus dans les zones de coin, les montants étant réalisés plus courts par rapport aux angles,
une gorge périphérique (6) s'étendant entre les angles (5) et les montants (5') est formée dans les coquilles (2, 3) de boîtier,
un joint élastique (25) réalisé d'un seul tenant et présentant un cordon d'étanchéité (27) peut être inséré dans la gorge périphérique (6),
des pièces de coin (28) conformées sur le joint font saillie entre les angles (5) et les montants (5') espacés les uns des autres, et
des conformations (29) prévues sur les pièces de coin (28) reposent sur des faces frontales (9') des montants (5').

2. Boîtier de commande modulaire selon la revendication 1, **caractérisé en ce que**
une gorge (6') touchant la gorge périphérique (6) de manière perpendiculaire est prévue dans les bords des angles (5).

3. Boîtier de commande modulaire selon la revendication 1 ou 2, **caractérisé en ce que**
au moins un adaptateur (10), qui présente des éléments de raccordement électriques aptes à être insérés dans celui-ci, peut être inséré par coopération de formes dans des orifices (4, 4') du boîtier formés par les angles (5).

4. Boîtier de commande modulaire selon l'une des revendications précédentes, **caractérisé en ce que**
l'adaptateur (10, 10') est pourvu d'une collerette périphérique (12) qui s'engage dans la gorge périphérique (6, 6') de l'orifice (4, 4').

5. Boîtier de commande modulaire selon l'une des revendications précédentes, **caractérisé en ce que**
une pièce de tôle (20, 20') réalisée de manière rectangulaire peut être insérée dans la gorge périphérique (6, 6') des orifices (4, 4'), la pièce de tôle présentant sur les petits côtés des chanfreins s'étendant depuis le centre (22) vers les bords (24).

6. Boîtier de commande modulaire selon l'une des revendications précédentes, **caractérisé en ce que**
au moins une plaque de montage ou une carte de circuits imprimés (30) peut être montée dans le boîtier (1) sur un support (7) en forme de socle.

7. Boîtier de commande modulaire selon l'une des revendications précédentes, **caractérisé en ce que**
les éléments de raccordement électriques qui peuvent être insérés dans l'adaptateur (10, 10') sont réalisés sous forme de connecteurs à fiches (18, 18').

8. Boîtier de commande modulaire selon l'une des revendications précédentes, **caractérisé en ce que**
la face extérieure de la coquille (2, 3) de boîtier est pourvue de bandes profilées (8) en relief.
